# EUROPEAN PATENT APPLICATION

(11) **EP 3 051 590 A1**
(43) Date of publication of application: **03.08.2016**
(21) Application number: 15153239.7
(22) Date of filing: 30.01.2015
(51) Int. Cl.: H01L 29/417, H01L 29/861

(54) **High power fast recovery diode**

(71) Applicant: ABB Technology AG, 8050 Zürich (CH)
(72) Inventor: Homola, Jaroslav, 27201 Kladno (CZ); Podzemsky, Jiri, 43401 Most (CZ); Pina, Libor, 19300 Praha 9 (CZ)
(74) Representative: ABB Patent Attorneys

(57) **Abstract**

It is the object of the invention to provide a power semiconductor diode which shows soft and fast recovery as well as robustness in hard dynamic conditions such as fast switching from high forward current to the reverse state with high reverse voltage. The object is attained by a power semiconductor diode comprising a semiconductor wafer (11) having a first main side (12) and a second main side (13) parallel to the first main side (12), wherein the semiconductor wafer (11) includes in the order from the first main side (12) to the second main side (13): a p-type anode base layer (14); a low doped n-type layer (15) forming a pn-junction with the p-type anode base layer (14); and a highly doped n-type emitter layer (16) having a net doping concentration which is higher than that of the low doped n-type layer (15), wherein a molybdenum disc (19) is firmly connected to the first main side (12) of the semiconductor wafer (11) as an anode electrode, andthe anode base layer (14) has a peak net doping concentration of 5·10¹⁶ cm⁻³ or less.

## Description

### Field of the invention

The present invention relates to power semiconductor diode according to the preamble of claim 1. In particular the invention relates to a high power fast recovery diode (FRD).

### Background of the invention

Circuits with fast switching components such an insulated gate commutated thyristor (IGCT) or an insulated gate bipolar transistor (IGBT) use FRDs as freewheeling diodes, clamping diodes or neutral-point clamped (NPC) diodes. Apart from a high maximum reverse voltage and high current capability also fast and soft recovery characteristics and a wide safe operating area (SOA) are required from the FRDs in these circuits. The FRDs have to be robust in hard dynamic conditions such as fast switching from forward current of several thousand amperes to the reverse state with a reverse voltage of several thousand volts with a rate of the fall of the diode current di/dt of hundreds to thousands amperes per microsecond. The failure of the FRDs used in the before-mentioned circuits would cause subsequent failure of the respective expensive switching components such as the before mentioned IGCT or IGBT.

High power applications with faster switching devices result in lower overall losses. Unfortunately, a high commutation rate of an IGCT or IGBT in combination with a short diode tail current triggers oscillations of the antiparallel freewheeling diode with overshoot voltages that could in worst case exceed maximum reverse voltage of the diode. Some charge of electrons and holes in the n-type base of the diode is needed after the commutation to ensure soft recovery of the diode. However, excessive charge of holes influences on the other hand the space charge distribution at the reverse junction and could cause a dynamic voltage breakdown of the diode. Known solutions try to improve the trade-off between soft recovery and robustness of the FRD by increasing the thickness of the semiconductor wafer or by local control of minority carriers' lifetime by proton irradiation. These known solutions have, however, a negative impact on other parameters of the FRD or on manufacturing costs.

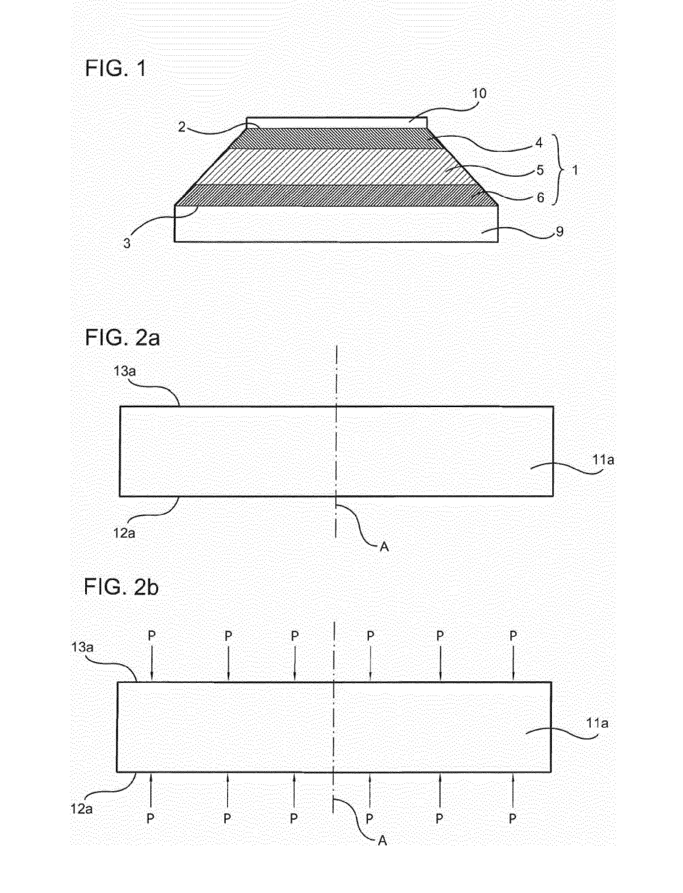

In prior art document CZ 301460 B6 there is offered a partial solution to this problem by a specific doping profile in a diode as shown in Fig. 1. The diode 1 disclosed in CZ 301460 B6 comprises a silicon wafer 1 having a first main side 2 and a second main side 3. In the order from its first main side 2 to its second main side 3, the silicon wafer 1 includes a p-type anode base layer 4, a low doped n-type layer 5 and a highly doped n-type emitter layer 6. The diode disclosed in CZ 301460 B6 makes use of a low doped anode base layer 4 with a concentration of electrically active dopants of less than 5·10¹⁶ cm⁻³ in combination with a molybdenum disc 9 fixed to the emitter side of the diode and a negative bevel edge termination. On the anode side there is provided an anode electrode 10. Such diode has an intensity of the electric field near the bevel higher than that in the bulk which has a negative effect on its blocking capability, robustness and SOA. Moreover, compared to a positive bevel, where a bevel angle of about 60° might be used, the negative bevel also decreases the current capability of the device as the angel of the negative bevel must be very small (lower than 3°) and the active area of the device is therefore decreased.

A high power diode with an anode net doping concentration of p = 10¹⁹ cm⁻³ with a molybdenum disc firmly fixed to the anode side and a positive bevel edge termination is known to the applicant. However, good results with regard to softness and robustness at the same time could not be achieved in the prior art with a molybdenum disc attached to the anode side and a corresponding positive bevel edge termination.

### Summary of the invention

It is the object of the invention to provide a power semiconductor diode which shows soft and fast recovery as well as robustness in hard dynamic conditions such as fast switching from high forward current to the reverse state with high reverse voltage, and to provide a method for manufacturing such power semiconductor diode.

The object is attained by a high power fast recovery diode according to claim 1 and a method for manufacturing such high power fast recovery diode according to claim 13. Further developments of the invention are specified in the dependent claims.

In the high power fast recovery diode of the invention a low peak net doping concentration in the anode layer can ensure a soft and fast recovery. Throughout this specification, a net doping concentration is the absolute value of the difference between the concentration of n-type dopants and p-type dopants. The peak net doping concentration of a region is the maximum net doping concentration in this region. Fixing a molybdenum disc to the anode side allows for a positive bevel edge termination which allows approximately 100% of the volume blocking capability and a wide SOA. Accordingly, in the invention the robustness of the high power fast recovery diode can be improved. Surprisingly, in the invention fixing the molybdenum disc to the anode side does not sacrifice the robustness. The inventors found out that in the prior art fixing the molybdenum disc to the anode side resulted in a highly doped p-type recrystallization layer adjacent to the surface of the anode base layer. Due to the highly doped p-type recrystallization layer adjacent to the surface of the anode base layer the soft recovery characteristics and robustness was impaired. However, when it was ensured that a low peak net doping concentration in the anode base layer was maintained during fixing the molybdenum disc to the anode side, the soft recovery characteristics and robustness could be improved.

In an exemplary embodiment the peak net doping concentration is 5·10¹⁵ cm⁻³ or more. In this exemplary embodiment the soft recovery characteristics and robustness can be combined with high blocking voltage and high current capability.

In an exemplary embodiment the pn-junction between the anode base layer and the low doped n-type layer is formed at a distance of at least 70 µm from the surface of the anode base layer on the first main side of the semiconductor wafer. In this exemplary embodiment the robustness is further improved.

In an exemplary embodiment the peak net concentration in the emitter layer is at least 1·10¹⁹ cm⁻³ or higher. In this exemplary embodiment the current capability can be improved.

In an exemplary embodiment the semiconductor wafer has a circular shape and an edge termination with positive bevel angle such that the diameter of the circular wafer is decreasing from the first main side to the second main side. In this exemplary embodiment the blocking capability can be increased to approximately 100% of the volume blocking capability. That means that the robustness of the device is improved. In an exemplary embodiment the bevel angle is in a range between 30° and 70° from the first main surface.

In an exemplary embodiment a metal interlayer is formed between the molybdenum disc and the anode base layer. In this exemplary embodiment formation of a highly doped anode base layer can be prevented in a reliable and efficient manner. In an exemplary embodiment the material of the metal interlayer is silver (Ag). With a thickness of at least 1 µm the metal interlayer can protect the semiconductor wafer from any unintentional p-type doping by dopants from the side of the molybdenum disc.

In an exemplary embodiment the molybdenum disc is fixed to the metal interlayer on the semiconductor wafer by an aluminium silicon alloy layer or by an aluminium layer. In this exemplary embodiment the molybdenum disc can be firmly and reliably fixed to the semiconductor wafer. At the same time a good electrical and thermal contact is formed between the molybdenum disc and the silicon wafer. With the molybdenum disc firmly fixed to the silicon wafer, the exact and reproducible formation of a positive bevel edge termination by grinding is facilitated.

### Brief description of the drawings

Detailed embodiments of the invention will be explained below with reference to the accompanying figures, in which
- Fig. 1: is a cross-sectional view of a known high power fast recovery diode;
- Figs. 2a to 2i: illustrate different steps in a method for manufacturing a high power fast recovery diode, which is a method for manufacturing a power semiconductor diode according to an embodiment of the invention; and
- Fig. 2j: shows a high power fast recovery diode, which is a power semiconductor diode according to an embodiment of the invention and which can be manufactured by a method as illustrated in Figs. 2a to 2i.

The reference signs used in the figures and their meanings are summarized in the list of reference signs. Generally, similar elements have the same reference signs throughout the specification. The described embodiments are meant as examples and shall not limit the scope of the invention.

### Detailed Description of exemplary embodiments

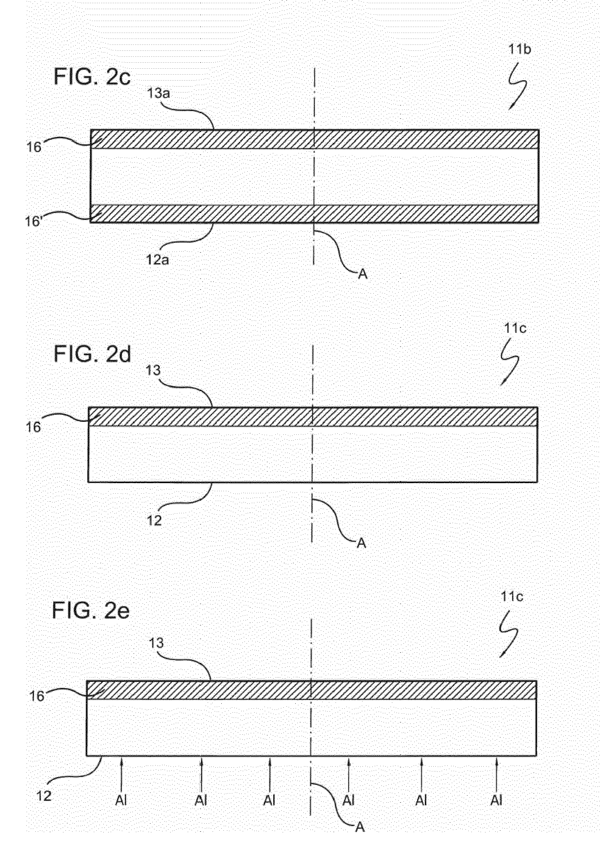

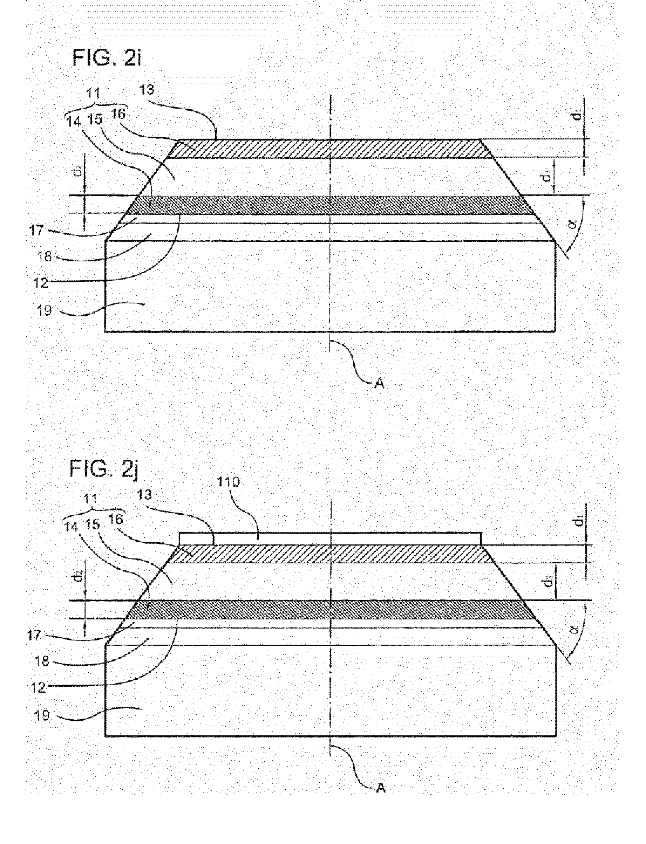

Fig. 2j shows an embodiment of a high power fast recovery diode (FRD) according to an embodiment of the invention. The FRD comprises a silicon wafer 11 having a first main side 12 and a second main side 13 parallel to the first main side 12. The silicon wafer 11 includes in the order from the first main side 12 to the second main side 13 a p-type anode base layer 14, a low doped n-type layer 15 and a highly doped n-type emitter layer 16. The p-type anode base layer 14 has a peak net doping concentration in a range from 5·10¹⁵ cm⁻³ to 5·10¹⁶ cm⁻³. In an exemplary embodiment the peak net doping concentration of the p-type anode base layer 14 is 2·10¹⁶ cm⁻³ or less. This can further improve the robustness and ensure a more soft recovery of the FRD. The thickness d₂ of the p-type anode base layer 14, which is the distance of the pn-junction formed between the p-type anode base layer 14 and the low doped n-type layer 15 from the surface of the anode base layer 14 on the first main side 12 of the silicon wafer 11 is at least 70 µm. The thickness d₃ of the low doped n-type layer 15 in a direction vertical to the first (second) main side 12 (13) of the silicon wafer 11 is in a range from 100 µm to 500 µm. The highly doped n-type emitter layer 16, which is formed adjacent to the second main side 13 of the silicon wafer 11 has a thickness d₁ of 70 µm or more in a direction vertical to the first (second) main side 12 (13) of the silicon wafer 11. The net doping concentration of the highly doped n-type emitter layer 16 is at least higher than the peak net doping concentration of the p-type anode base layer, exemplarily it is 1·10¹⁹ cm⁻³ or higher.

A silver (Ag) interlayer 17 is formed on the p-type anode base layer 14 on the first main side 12 of the silicon wafer 11. A molybdenum disc 19 is firmly connected to the first main side 12 of the silicon wafer 11 as an anode electrode by an aluminum silicon alloy layer 18 with the aluminum silicon alloy layer 18 interposed between the molybdenum disc 19 and the Ag interlayer 17. The Ag interlayer 17 has exemplarily a thickness of 1 µm or more to efficiently prevent diffusion of aluminum from the aluminum silicon alloy layer 18 into the silicon wafer 11 (during an annealing step to be described later). On the second main side 13 of the silicon wafer 11 there is formed a cathode electrode layer 110 forming an ohmic contact with the highly doped n-type emitter layer 16..

The whole device as shown in Fig. 2j has a rotational symmetry around rotational symmetry axis A vertical to the first main side 12 and the second main side 13. In particular, the silicon wafer 11 has a circular shape in top view, i.e. when viewed in a direction perpendicular to the first main side 12 and to the second main side 13. As shown in Fig. 2j the diode has a positive bevel edge termination with a bevel angle α in a range from 30° to 70° to relieve the edge from high electric fields under reverse bias conditions. The bevel angle α is defined as the angle between a first line parallel to the pn-junction and a second line parallel to the lateral edge as shown in Fig. 2j. A positive bevel edge termination means that the diameter of the circular silicon wafer 11 is decreasing from the first main side to the second main side.

In the following a method for manufacturing the FRD as shown in Fig. 2j is described with reference to Figs. 2a to 2i. The described method is an embodiment of the method for manufacturing a power semiconductor diode according to the invention.

In a first method step a low doped n-type silicon wafer 11a having a first main side 12a and a second main side 13a parallel to the first main side 12a is provided. The net doping concentration of the low doped n-type silicon wafer 11a is the same as that of low doped n-typed layer 15 in the final FRD. The silicon wafer 11a has a rotational symmetry axis A and is of circular shape in a top view (when viewed in a direction vertical to the first main side 12a and to the second main side 13a).

In a next method step phosphorous (P) as an n-type dopant is diffused into the silicon wafer 11a from both main sides 12a and 13a as shown in Fig. 2b. Fig. 2c shows the resulting silicon wafer 11b in cross-section. Silicon wafer 11b comprises adjacent to its first main side 12a a highly doped n-typed layer 16' and adjacent to the second main side 13a a highly doped n-typed layer 16 which will be the highly doped n-type emitter layer 16 in the final FRD.

In a next method step illustrated in Fig. 2d the highly doped n-type layer 16' adjacent to the first main side of the silicon wafer 11b is removed to obtain silicon wafer 11c as shown in Fig. 2d.

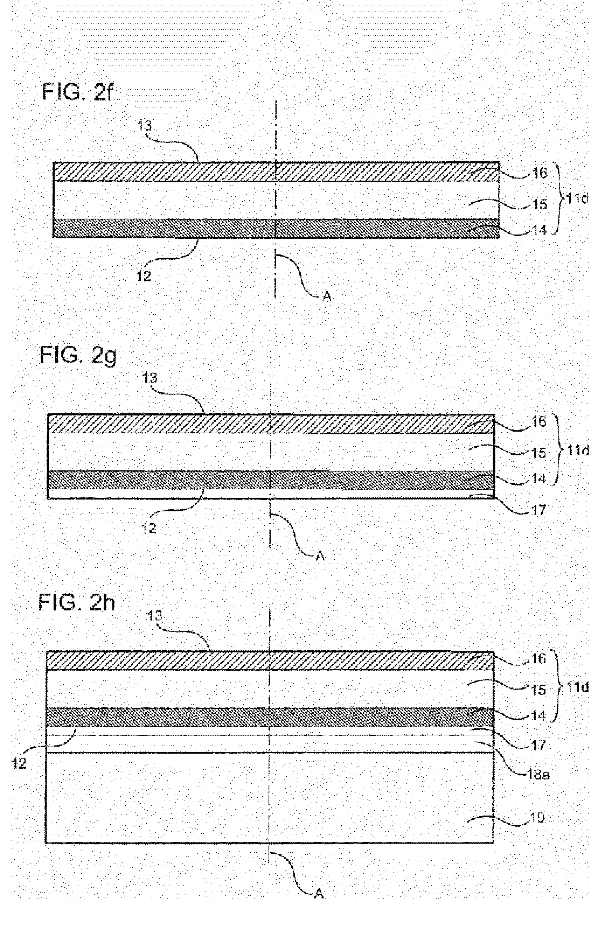

After removal of the highly doped n-typed layer 16' aluminum (Al) as a p-type dopant is diffused into silicon wafer 11c from its first main side 12. The resultant silicon wafer 11d is shown in Fig. 2f. Silicon wafer 11d has a p-type doped layer adjacent to the first main side 12 of the silicon wafer 11d which will become the p-type anode base layer 14 in the final FRD.

As shown in Fig. 2g an Ag interlayer 17 is formed on the first main side 12 of silicon wafer 11d.

In a next method step illustrated in Fig. 2h a stack of the silicon wafer 11d with the Ag interlayer 17 formed on its first main side, a silicon aluminum alloy foil 18a and a molybdenum disc 19 is formed in this order so that the silicon aluminum foil 18a is sandwiched between Ag interlayer 17 and the molybdenum disc 19. This stack is then annealed at a temperature between 500°C and 700°C, preferably at a temperature below 620°C. In this way the molybdenum disc 19 is alloyed to the silicon wafer 11d with the Ag interlayer 17 and a silicon aluminum alloy layer 18 interposed there between. During the annealing step the Ag interlayer 17 separates the aluminum silicon alloy layer 18a and prevents incorporation of aluminum from the aluminum silicon alloy foil 18a into the silicon wafer 11.

As shown in Fig. 2i a positive bevel edge termination is formed by mechanical grinding or chemical mechanical polishing (CMP) after the molybdenum disc 19 is firmly fixed to the silicon wafer 11. The bevel angle α formed in this method step has a value between 30° and 70°.

In another method step the cathode electrode 110 is formed on the second main side 13 of the silicon wafer 11 to obtain the final FRD as shown in Fig. 2j.

It will be apparent for persons skilled in the art that modifications of the above described embodiments are possible without departing from the idea of the invention as defined by the appended claims.

In the above embodiments it was described that an Ag interlayer 17 is formed on the first main side 12 of the silicon wafer 11. However, instead of the Ag interlayer 17 any other metal interlayer forming a good electrical contact with the silicon wafer 11 and the aluminium silicon alloy layer 18 can be used as long as it is thick enough to function as an effective barrier for aluminium to block incorporation from the aluminium silicon alloy layer 18 into the silicon wafer 11. Such metal interlayer includes also multilayers such as a stack of an Ag layer, a nickel layer and a titanium layer (Ti-Ni-Ag multilayer) in this order from the silicon wafer 11 towards the molybdenum disc 19.

In the above embodiment there was used an aluminium silicon alloy layer 18 to connect the molybdenum disc 19 to the silicon wafer 11. However, instead of an aluminium silicon alloy layer 18 an aluminium layer may be used to connect the molybdenum disc 19 to the silicon wafer 11. In this case an aluminium layer is used instead of aluminium silicon alloy foil 18a.

In the above described method for manufacturing the FRD, A1 was used as a p-type dopant and P was used as an n-type dopant. However, other dopants might be used for forming the n-type and p-type regions. Also the dopants may not only be incorporated by diffusion into the silicon wafer 11 but also by any other known method such as by implantation, for example.

In the above described method for manufacturing the FRD, the cathode electrode 110 was formed in a final method step after the grinding step for forming the positive bevel termination. However, the cathode electrode 110 also be formed before at any time after forming the highly doped n-type emitter layer 16.

In any of the above embodiments the silicon wafer 11 may be treated by electron irradiation to form recombination centres. It is an advantage for the robustness of the diode to irradiate the bevel region of the silicon wafer 11 with a dose of electrons several times (at least 4 times) higher than in the wafer region outside the bevel or edge termination region (i.e. in the active central part of the diode).

It should be noted that the term "comprising" does not exclude other elements or steps and that the indefinite article "a" or "an" does not exclude the plural. Also elements described in association with different embodiments may be combined.

### List of reference signs

- 1: silicon wafer
- 2: first main side
- 3: second main side
- 4: p-type anode base layer
- 5: low doped n-type layer
- 6: highly doped n-type emitter layer
- 9: molybdenum disc
- 10: anode electrode
- 11a: silicon wafer
- 11b: silicon wafer
- 11c: silicon wafer
- 11d: silicon wafer
- 11: silicon wafer
- 12: first main side
- 12a: first main side
- 13: second main side
- 13a: second main side
- 14: p-type anode base layer
- 15: low doped n-type layer
- 16: highly doped n-type emitter layer
- 16': highly doped n-type layer
- 17: silver (Ag) interlayer
- 18: silicon aluminum alloy layer
- 19: molybdenum disc
- 110: cathode electrode
- d₁: thickness of the highly doped n-type emitter layer
- d₂: thickness of the low doped n-type layer
- d₃: thickness of the p-type anode base layer
- A: rotational symmetry axis
- Al: aluminum
- P: phosphorous

## Claims

1. Power semiconductor diode comprising a semiconductor wafer (11) having a first main side (12) and a second main side (13) parallel to the first main side (12), wherein the semiconductor wafer (11) includes in the order from the first main side (12) to the second main side (13):
a p-type anode base layer (14);
a low doped n-type layer (15) forming a pn-junction with the p-type anode base layer (14); and
a highly doped n-type emitter layer (16) having a net doping concentration which is higher than that of the low doped n-type layer (15);
**characterized in that** a molybdenum disc (19) is firmly connected to the first main side (12) of the semiconductor wafer (11) as an anode electrode, and
the anode base layer (14) has a peak net doping concentration of 5·10¹⁶ cm⁻³ or less.

2. Power semiconductor diode according to claim 1, wherein the p-type anode base layer (14) has a peak net doping concentration of 5·10¹⁵ cm⁻³ or more.

3. Power semiconductor diode according to claim 1 or 2, wherein the pn-junction is formed at a distance of at least 70 µm from the surface of the p-type anode base layer (14) on the first main side (12) of the semiconductor wafer (11).

4. Power semiconductor diode according to anyone of claims 1 to 3, wherein the net concentration in the highly doped n-type emitter layer (16) is at least 1·10¹⁹ cm⁻³ or higher.

5. Power semiconductor diode according to anyone of claims 1 to 4, wherein the semiconductor wafer (11) has a circular shape and an edge termination with positive bevel angle (α) such that the diameter of the circular semiconductor wafer (11) is decreasing from the first main side (12) to the second main side (13).

6. Power semiconductor diode according to anyone of claim 5, wherein the bevel angle (α) is an angle between 30° and 70° from the first main surface (12).

7. Power semiconductor diode according to anyone of claims 1 to 6, wherein a metal interlayer (17) is formed between the molybdenum disc (19) and the p-type anode base layer (14).

8. Power semiconductor diode according to claim 7, wherein the material of the metal interlayer is silver (Ag).

9. Power semiconductor diode according to claim 7 or 8, wherein the metal interlayer (17) has a thickness of at least 1 µm.

10. Power semiconductor diode according to anyone of claims 7 to 9, wherein the molybdenum disc (19) is fixed to the metal interlayer (17) on the semiconductor wafer (11) by an aluminium silicon alloy layer (18) or by an aluminium layer.

11. Power semiconductor diode according to anyone of claims 1 to 10, wherein the semiconductor wafer (11) is made of silicon.

12. Power semiconductor diode according to anyone of claims 1 to 11, wherein the thickness (d₁) of the highly doped n-type emitter layer (16) is 70 µm or more.

13. Method for manufacturing a power semiconductor diode according to anyone of claims 1 to 12, wherein the method comprises the following steps:
providing a low doped n-type semiconductor wafer (11a) having a first main side (12a) and a second main side (13a);
implanting or diffusing an n-type dopant into the low doped n-type semiconductor wafer (11a) from its second main side (13a) to form the highly doped n-type emitter layer (16),
implanting or diffusing a p-type dopant into the low doped n-type semiconductor wafer (11a) from its first main side (12a) to form the p-type anode base layer (14);
forming the metal interlayer (17) onto the p-type anode base layer (14); and
fixing the molybdenum disc (19) onto the metal interlayer (17),
wherein the layer of the low doped semiconductor wafer (11a) between the p-type anode base layer (14) and the highly doped n-type emitter layer (16) is the low doped n-type layer (15).

14. Method according to claim 13, wherein the step of fixing the molybdenum disc (19) onto the metal interlayer (17) includes the step of annealing a stack of the metal interlayer (17), an aluminium silicon alloy layer (18) or an aluminium layer, and the molybdenum disc (19) at an annealing temperature of between 500°C and 700°C.

15. Method according to claim 14, wherein the annealing temperature is below 620°C.
